# EUROPEAN PATENT APPLICATION

(11) **EP 4 394 883 A1**
(43) Date of publication of application: **03.07.2024**
(21) Application number: 22217365.0
(22) Date of filing: 30.12.2022
(51) Int. Cl.: H01L 29/08, H01L 29/06, H01L 29/739, H01L 21/331, H01L 29/417, H01L 29/40

(54) **REVERSE-CONDUCTING INSULATED GATE BIPOLAR TRANSISTOR AND METHOD FOR PRODUCING A REVERSE-CONDUCTING INSULATED GATE BIPOLAR TRANSISTOR**

(71) Applicant: Hitachi Energy Ltd, 8050 Zürich (CH)
(72) Inventor: BUITRAGO, Elizabeth, 5210 Windisch (CH); DE-MICHIELIS, Luca, 5000 Aarau (CH); BOKSTEEN, Boni Kofi, 5600 Lenzburg (CH)
(74) Representative: Epping - Hermann - Fischer

(57) **Abstract**

According to an embodiment, the RC-IGBT (100) comprises a semiconductor body (10) with an emitter side (11) and a collector side (19). The semiconductor body comprises at least one mixed region (18) at the collector side. The mixed region comprises a plurality of first-type regions (15) which are of a first conductivity type and which are laterally spaced apart from each other by semiconductor material of a second conductivity type. In top view onto the collector side, the first-type regions of the mixed region are each formed in an elongated manner and each extend ray-like away from a reference point of the mixed region. The number of first-type regions of the mixed region increases stepwise in a direction away from the reference point.

## Description

The present disclosure relates to a Reverse-Conducting Insulated Gate Bipolar Transistor and a method for producing a Reverse-Conducting Insulated Gate Bipolar Transistor.

There is a need for an improved Reverse-Conducting Insulated Gate Bipolar Transistor, e.g. for one which has improved reverse conducting properties and/or ameliorated secondary snapback events. Furthermore, there is a need for a method for producing such a Reverse-Conducting Insulated Gate Bipolar Transistor.

Embodiments of the disclosure relate to a Reverse-Conducting Insulated Gate Bipolar Transistor and a method for producing a Reverse-Conducting Insulated Gate Bipolar Transistor.

First, the Reverse-Conducting Insulated Gate Bipolar Transistor is specified. In the following, the abbreviation RC-IGBT for the expression "Reverse-Conducting Insulated Gate Bipolar Transistor" will be used.

According to an embodiment, the RC-IGBT comprises a semiconductor body with an emitter side and a collector side. The semiconductor body comprises at least one mixed region at the collector side. The mixed region comprises a plurality of first-type regions which are of a first conductivity type and which are laterally spaced apart from each other by semiconductor material of a second conductivity type. In top view onto the collector side, the first-type regions of the mixed region are each formed in an elongated manner and each extend ray-like away from a reference point of the mixed region. The number of first-type regions of the mixed region increases stepwise in a direction away from the reference point.

With the first-type regions in the ray-like and stepwise increasing arrangement, the desired diode area can be achieved and, at the same time, a snapback free device can be realized.

The RC-IGBT described herein is, in particular, a power device. It may be configured to carry an electric current of at least 10 A and/or to process voltages of at least 600 V and/or at most 6500 V. For example, the RC-IGBT is a low voltage device for operation between 1000 V and 2000 V.

The semiconductor body may be based on silicon or silicon carbide. The thickness of the semiconductor body, measured in a vertical direction from the collector side to the emitter side, is, for example, at least 60 µm and/or at most 700 µm. For example, the thickness of the semiconductor body is at most 150 µm. The emitter side and the collector side are sides of the semiconductor body and delimit the semiconductor body in the vertical direction.

A first main electrode, namely a so-called "emitter electrode", may be arranged on the emitter side and is in electrical contact with the semiconductor body. A second main electrode, namely a so-called "collector electrode", is arranged on the collector side and is in electrical contact with the semiconductor body, particularly with the mixed region.

The mixed region is a region of the collector side, i.e. it adjoins the collector side or forms part thereof, respectively. The mixed region comprises a plurality of first-type regions, e.g. at least 20 or at least 50 first-type regions. The first-type regions also adjoin the collector side, i.e. each form a part thereof.

The RC-IGBT may comprise a plurality of mixed regions. All features disclosed here in connection with one mixed region are also disclosed for the other mixed regions.

The first-type regions are of a first conductivity type which may be n-type. Thus, the first-type regions may be n-doped. However, alternatively, it is also possible that the first conductivity type is p-type.

The first-type regions are laterally spaced apart from each other in lateral direction, where lateral directions are directions perpendicular to the vertical direction. The lateral directions are, in particular, directions parallel to the collector side and/or parallel to the main extension plane of the semiconductor body. For example, in top view onto the collector side, each first-type region is formed contiguously and without interruptions.

The first-type regions are separated from each other by semiconductor material of a second conductivity type. The second conductivity type is opposite to the first conductivity type. Thus, in the case of the first conductivity type being n-type, the second conductivity type is p-type. Each first-type region may be laterally completely surrounded by semiconductor material of the second conductivity type. The semiconductor material of the second conductivity type arranged between the first-type regions also adjoins the collector side, i.e. forms part thereof.

The first-type regions are elongated when seen in top view onto the collector site. For example, the first-type regions are all formed as stripes. Furthermore, when seen in top view onto the collector side, the first-type regions extend away from the reference point of the mixed region like rays. That is, some or all first-type regions are mainly or completely orientated in radial directions. Radial directions are lateral directions pointing from the reference point away from the reference point. Particularly, some or all main extension directions of the elongated, first-type regions are parallel or almost parallel to radial directions.

For example, when viewed in the top view onto the collector side, the main extension directions of some or all elongated first-type regions extend perpendicularly to the contour of a circle or an ellipse with the reference point lying in the center of the circle or ellipse.

The number of first-type regions in the mixed region increases stepwise in a direction away from the reference point. This means that, when considering a certain azimuthal sector (polar angle sector) covered by the mixed region, the number of first-type regions completely lying in this azimuthal sector is greater in a region which is further away from the reference point than in the region which is closer to the reference point. The azimuthal sector may be 360° or may be a smaller azimuthal sector, e.g. of at most 20° and/or at least 5°. Azimuthal angles or azimuthal sectors are defined with respect to the reference point.

"Stepwise" means that the number of first-type regions does not increase continuously but in steps. In top view onto the collector side, each step is assigned a certain area of the mixed region. The steps are arranged one after the other in a direction away from the reference point. For example, the step closest to the reference point has the lowest number of first-type regions and the step furthest away from the reference point has the highest number of first-type regions. When comparing the number of first-type regions in different steps, only the first-type regions within the (same) azimuthal sector are counted.

For instance, in each step or at least in the step closest to the reference point, all the first-type regions have the same length, wherein the length is measured along the main extension direction of the respective first-type region. The first-type regions of different steps may have different lengths.

For example, the mixed region comprises two or more steps, particularly three or more steps for which the number of first-type regions is greater the further away the step is from the reference point. For instance, the mixed region comprises at most ten such steps arranged one after the other in a direction away from the reference point.

According to a further embodiment, the semiconductor body comprises a pilot region at the collector side. The pilot region adjoins the mixed region. The pilot region is of the second conductivity type. Accordingly, the RC-IGBT may be a so-called "Bi-Mode Insulated Gate Transistor", BIGT for short. The terms "pilot region" and "BIGT" are well known to the skilled person. The pilot region forms part of the collector side.

The pilot region is a region of the device which is a pure IGBT, and the mixed region is a region where the RC-IGBT is actually formed. Particularly, the pilot region is a contiguous region at the emitter side, for example a region without interruptions.

When viewed in top view onto the collector side, the pilot region has, particularly, a greater area than each of the first-type regions, e.g. at least 5-times or at 10-times greater. The pilot region adjoins the collector electrode, for example. The size of the pilot region is chosen such that it reduces snapbacks. On the other hand, it could be advantageous to choose the pilot region to be as small as possible in order to keep the area of the RC-IGBT large. For example, the area of the pilot region, when seen in top view onto the top side, is at least d·d and at most 100·d·d, wherein d is the thickness of the semiconductor body measured in vertical direction. This range has turned out to fulfill the above-mentioned conditions.

According to a further embodiment, in top view onto the collector side, the reference point lies in the pilot region. For example, the reference point coincides with center of gravity of the pilot region.

With the reference point lying in the pilot region, the first-type regions extend like rays away from the pilot region. With the arrangement of the first-type regions, a homogeneous plasma distribution along the extension of the RC-IGBT can also be achieved for low voltage applications, i.e. with a comparatively small thickness of the semiconductor body, as well as a good thermal performance.

According to a further embodiment, in top view onto the collector side, the mixed region completely surrounds the pilot region. In other words, the pilot region is laterally completely surrounded by the mixed region. This means that the mixed region covers an azimuthal sector of 360°.

According to a further embodiment, in top view onto the collector side, a second-type region of the second conductivity type extends contiguously from the pilot region to an edge of the mixed region. The edge of the mixed region is the part of the mixed region most distant from the reference point. The second-type region is, for example, a contiguous region which is punctuated by several first-type regions. The second-type region may extend over the whole azimuthal sector covered by the mixed region. For example, the second-type region extends over an azimuthal sector of 360°, i.e. completely surrounds the reference point and/or the pilot region. Particularly, the second-type region is formed by the semiconductor material of the second conductivity type arranged between the first-type regions.

Such a contiguously formed second-type region further helps to homogeneously distribute the plasma produced during operation.

According to a further embodiment, in top view onto the collector side, the first-type regions are evenly distributed around the reference point. For example, for each pair of adjacent first-type regions within one step, the minimum distance between the adjacent first-type regions is the same.

Additionally or alternatively, in top view onto the collector side, the mixed region may have an n-fold rotational symmetry with respect to the reference point. The integer n is, for example, at least 10 or at least 30 or at least 50 or at least 100.

According to a further embodiment, in top view onto the collector side, each step of the stepwise increase is assigned an area of the collector side.

According to a further embodiment, the area assigned to at least one step is ring-shaped, e.g. shaped as an elliptic ring or circular ring. For example, the areas assigned to two or more steps are ring-shaped. The rings are concentric with respect to each other.

For example, the first-type regions each have a first longitudinal end which is closest to the reference point and a second longitudinal end which is furthest away from the reference point. In top view onto the collector side, the first longitudinal ends of the first-type regions may lie on contours of different ellipses or a circles around the reference point. These contours define the borders of the ring-shaped areas of the steps.

For instance, in top view, a first such contour surrounding the smallest area crosses a first number of first longitudinal ends. The first number is, e.g. at least 10. A second such contour surrounds a larger area and crosses a second number of first longitudinal ends, wherein the second number is greater than the first number, e.g. at least two times as great as the first number. Moreover, there may be a third such contour which surrounds an even larger area and which crosses a third number of first longitudinal ends, wherein the third number may be larger than the second number. The contours may be concentric with respect to the reference point.

According to a further embodiment, the number of first-type regions changes from one step to the adjacent step by a factor of at least 2 or at least 3 or at least 5.

According to a further embodiment, within a step, i.e. within the area assigned to this step, the distance between two adjacent first-type regions, particularly the distance in each pair of adjacent first-type regions, has a first value in the region closest to the reference point and has a second value at a region furthest away from the reference point. The second value is greater than the first value. That is, the distance between the two adjacent first-type regions, particularly the distance in each pair of adjacent first-type regions, increases when moving away from the reference point. For example, the distance increases gradually or continuously, respectively.

When talking about adjacent first-type regions within a step, this means that the first-type regions are adjacent in azimuthal direction. In radial direction, the two adjacent first-type regions may lie on the same height or same position, respectively.

According to a further embodiment, the second value is at most 4-times the first value. Particularly, the mixed region is formed such that when moving away from the reference point and before the ratio of the second value to the first value exceeds the number 4, the next step starts in which the number of first-type regions is increased. For example, in the area arranged azimuthally between the two adjacent first-type regions, when changing from one step to the next step a new first-type region is formed which has an increased number of first-type regions.

By way of example, some first-type regions start in a step and, from thereon, extend over one or more further steps, which are further away from the reference point than the step in which the first-type region starts.

By way of example, at least some or all first-type regions only extend over one step. That is, these first-type regions can be unambiguously assigned to one step. However, some or all of these first-type regions in at least one step may be assigned a partner first-type region in the next step further away from the reference point, wherein the first-type region and the assigned partner first-type region are orientated in the same direction and/or have the same azimuthal position, i.e. have the same position in azimuthal direction.

According to a further embodiment, the maximum distance between two adjacent first-type regions in one step is greater than the minimum distance between two adjacent first-type regions in the next step located downstream of the one step in the direction away from the reference point.

According to a further embodiment, the width of the first-type regions, measured perpendicularly to their respective main extension directions, is at most half of the first value or at most 1/4 of the first value or at most 1/6 of the first value.

According to a further embodiment, the RC-IGBT further comprises a plurality of transistor half-cells arranged one after the other in a first lateral direction. Each transistor half-cell comprises, for example, one injection region, also called source region, of the first conductivity type. The injection region is in electrical contact with the emitter electrode which is arranged on the top side. For example, the injection region adjoins the emitter electrode. For example, the injection region reaches as far as the emitter side. The injection region may be a contiguous region, for example without interruptions. Each transistor half-cell may be assigned exactly one injection region on a one-to-one basis.

Besides the injection regions, the semiconductor body comprises at least one base region and a drift region. The drift region is of the first conductivity type. The drift region is arranged vertically between the emitter side and the mixed region and/or the pilot region. The drift region may adjoin the mixed region and/or the pilot region. The at least one base region is arranged vertically between the emitter side and the drift region. The at least one base region is of the second conductivity type. Each injection region is spaced apart from the drift region by the at least one base region, for example spaced apart in lateral and/or vertical direction. For example, each injection region and, accordingly, each transistor half-cell may be assigned an individual base region. All the transistor half-cells may be formed identically within the limits of manufacturing tolerance.

The RC-IGBT may be of planar architecture or trench architecture. Trench architecture means that there are several trenches (e.g. two per half-cell) which extend from the emitter side into the semiconductor body. The gate electrode of the RC-IGBT extends into at least some of the trenches. In planar architecture, the gate electrode is arranged on the emitter side of the semiconductor body.

According to a further embodiment, the extensions of the transistor half-cells measured in the first lateral direction are smaller than the widths of the first-type regions. For example, the ratio between the width of a first-type region and the extension of a transistor half-cell is at least 1.2 and/or at most 5. The extensions of the transistor half-cells are, for example, defined as the pitch between two adjacent transistor half-cells in the first lateral direction.

According to a further embodiment, when viewed in top view onto the collector side, the pilot region has a round shape. For example, the pilot region has the shape of a circle or of an ellipse. Particularly, the pilot region may be delimited by a contour following the relation x²/a² + y²/b² = 1, with x and y being the coordinates on the collector side with the center of the pilot region having the coordinates x = 0 and y = 0 and with a and b being fixed numbers. The center of the pilot region may be the center of gravity of the pilot region. The center of the pilot region may coincide with the reference point. For example, the main extension directions of the first-type regions are perpendicular to this contour.

According to a further embodiment, the collector side has a rectangular shape with the edges of the rectangle having the length L and the width W. Thereby, L ≥ W. For example, L and W are at least 1 mm and/or at most 20 mm.

According to a further embodiment, the area and shape of the pilot region is chosen in dependence on the area and shape of the collector side according to the following rules:
- if L < 2·W, then the collector side comprises only one pilot region surrounded by a mixed region, wherein the contour delimiting the pilot region fulfills 0.1 ≤ (2·a)/L ≤ 0.5, 0.1 ≤ (2·b)/W ≤ 0.5 and (2·a)/L = (2·b)/W, and
- if L ≥ 2·W, then the collector side comprises several pilot regions each surrounded by a mixed region and each pilot region being delimited by a contour which fulfills 0.1 ≤ (2·a)/L' ≤ 0.5, 0.1 ≤ (2·b)/W ≤ 0.5 and (2·a)/L' = (2·b)/W with L'·c = L, c being an integer and being the number of pilot regions. Particularly, L' ≥ W.

In other words, if the length L is less than 2-times greater than the width W, then the RC-IGBT only comprises one pilot region and one mixed region at the collector side. If the length L is at least 2-times greater than the width W but less than 3-times greater than the width W, then the RC-IGBT comprises exactly two mixed regions and exactly two assigned pilot regions and so on. Moreover, if the shape of the collector side is that of a square, the pilot region has the form of a circle. In the case of several pilot regions, the pilot regions are spaced apart from each other in lateral direction.

With these design rules for the size of the pilot region, a good compromise between snapback reduction and homogeneous plasma contribution is obtained.

According to a further embodiment, the semiconductor body comprises an edge region at the collector side. The edge region may extend to the edge of the collector side, delimiting the collector side in lateral direction. For example, the edge region forms the edges of the collector side.

According to a further embodiment, the edge region is of the first conductivity type. Alternatively, the edge region is of the second conductivity type. Particularly, the edge region is a contiguous region consisting of only one conductivity type.

According to a further embodiment, the edge region laterally surrounds the mixed region and/or the pilot region. For example, the edge region laterally completely surrounds the mixed region and/or the pilot region. That is, in top view onto the collector side, the edge region may completely surround the mixed region and/or the edge region. For example, the edge region forms a frame around the mixed region and/or the pilot region in this top view.

In top view onto the collector side, the edge region may overlap with a termination region of the RC-IGBT. For example, the edge region completely or partially overlaps with the termination region of the RC-IGBT.

The area of the edge region, when viewed in top view onto the collector side, may be greater than the area of each of the first-type regions, e.g. at least 10-times greater. The edge region may have a constant width along its extension around the mixed region and/or the pilot region.

According to a further embodiment, the edge region is of the second conductivity type. For example, the edge region has a lower doping concentration than the semiconductor material of the second conductivity type in the mixed region arranged laterally between the first-type regions. For example, the doping concentration is at least one order or at least two orders of magnitude smaller than that of the semiconductor material of the second conductivity type in the mixed region. In this way, leakage can be reduced while SCSOA (hot) capability is further improved.

According to a further embodiment, the edge region is of the first conductivity type. The doping concentration may be the same or different from that in the first-type regions. With such an edge region, on-state loss in the diode operating mode can be reduced, since the emitter connected portion of the p-type termination region acts as an additional anode area for the BIGTs' internal diode.

Next, the method for producing an RC-IGBT is specified. The method may be used to produce the RC-IGBT as specified herein. Therefore, all features disclosed in connection with the RC-IGBT are also disclosed for the method and vice versa.

According to an embodiment, the method comprises a step of providing information which is representative for a length L and a width W to be had by a collector side of the to-be-produced RC-IGBT, wherein L ≥ W. Then, a semiconductor body with an emitter side and a collector side is produced depending on the provided information. The semiconductor body is produced such that the semiconductor body comprises at least one mixed region at the collector side. The mixed region comprises a plurality of first-type regions which are of a first conductivity type and which are laterally spaced apart from each other by semiconductor material of a second conductivity type. In top view onto the collector side, the first-type regions of the mixed region are each formed in an elongated manner and each extend ray-like away from a reference point of the mixed region. The number of first-type regions of the mixed region increases stepwise in a direction away from the reference point. If L ≥ 2·W, the semiconductor body is produced with two or more such mixed regions and, if L < 2·W, the semiconductor body is produced with only one such mixed region.

Hereinafter, the RC-IGBT and the method for producing an RC-IGBT will be explained in more detail with reference to drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.

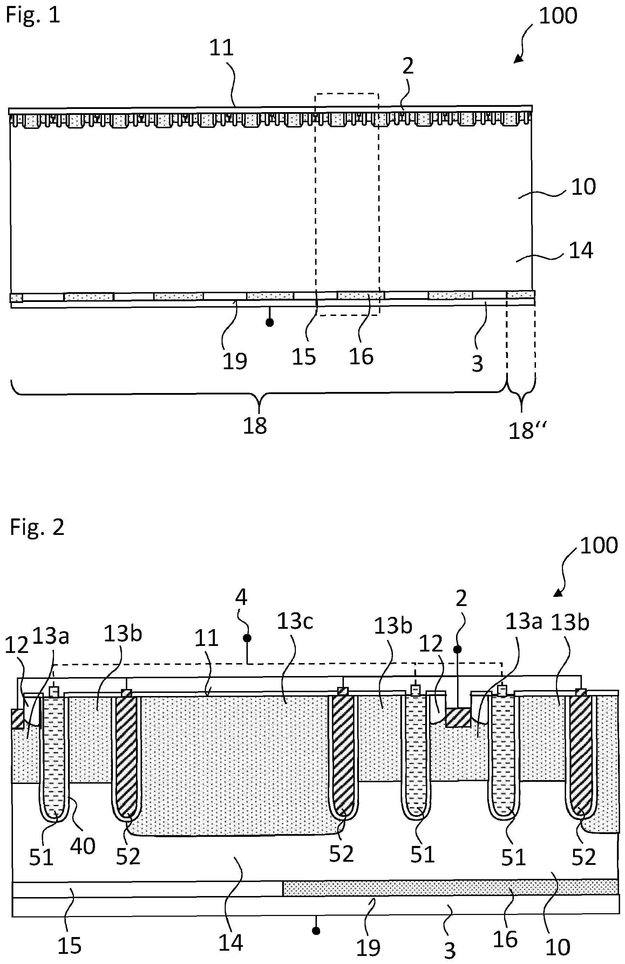

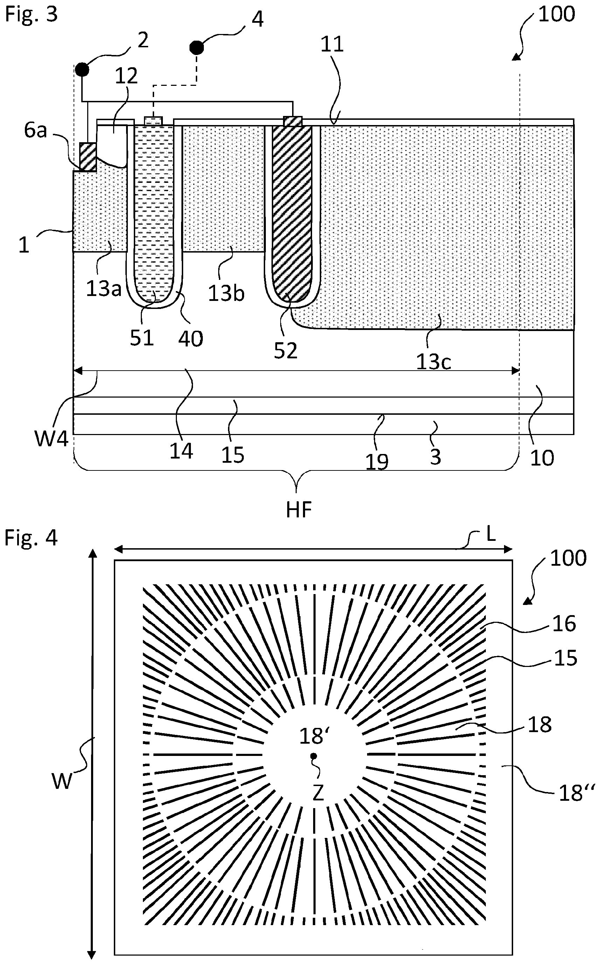

Figures 1 to 3 show a first exemplary embodiment of the RC-IGBT 100 in a cross-sectional view. Figure 2 shows the region of figure 1 indicated by the dashed rectangle in greater detail. Figure 3 shows a section of figure 2 in greater detail.

The RC-IGBT comprises a semiconductor body 10 with an emitter side 11 and a collector side 19, lying opposite to each other in a vertical direction. The semiconductor body 10 is based on Si or SiC, for example.

At the collector side 19, the semiconductor body 10 comprises first-type regions 15 and a second-type region 16, which are arranged in an alternating manner. They build-up a mixed region 18. The regions 15 and 16 are in electrical contact with a collector electrode 3 arranged on the bottom side 19. The collector electrode 3 is, for example, formed of metal.

The first-type regions 15 are of a first conductivity type, which is n-type in the following, and the second-type region 16 is of a second conductivity type, which is p-type in the following.

Furthermore, the semiconductor body 10 comprises an edge region 18'' which forms part of the collector side 19 and forms an edge of the collector side 19. The edge region 18'' is herein of the second conductivity type but, alternatively, could be of the first conductivity type.

A drift region 14 is arranged between the emitter side 11 and the collector side 19. The drift region 14 is of the first conductivity type, i.e. n-type. The drift region 14 adjoins the first-type regions 15 and the second-type region 16.

A plurality of trenches 51, 52 extend from the emitter side 11 into the semiconductor body 10 and into the drift region 14. The trenches 51 are first-type trenches, herein also called active trenches, and the trenches 52 are second-type trenches, herein also called inactive trenches or dummy trenches.

The first-type trenches 51 are filled with an electrically conductive material which is electrically separated from the semiconductor body 10 by an electrically insulating layer 40, herein called "gate insulation layer". Thus, there is no direct electrical contact between the semiconductor body 10 and the electrically conductive material in the first-type trenches 51. The gate insulation layer 40 is, for example, formed of an oxide, like SiO₂. The electrically conductive material in the first-type trenches 51 may be a highly-doped polysilicon. The electrically conductive material in the first-type trenches 51 is part of a gate electrode 4 of the semiconductor device 100.

The second-type trenches 52 are also filled with electrically conductive material, e.g. highly-doped polysilicon, which is also electrically separated from the semiconductor body 10 by an electrically insulating layer which is the same as the gate insulation layer 40. The electrically conductive material in the second-type trenches 52 is part of an emitter electrode 2 arranged on the emitter side 11. The first base regions 13a adjoin and are in electrical contact with the emitter electrode 2 in first contact areas 6a, also called "Rb-prime areas".

The semiconductor body 10 comprises several base regions 13a, 13b, 13c, which are arranged vertically between the drift region 14 and the emitter side 11. The base regions 13a, 13b, 13c are all of the second conductivity type, i.e. p-type, and they all adjoin the drift region 14 as well as the emitter side 11. First 13a and second 13b base regions are shallower (smaller vertical extension) than the trenches 51, 52. The third base region 13c is deeper than the trenches 51, 52, i.e. extends further into the semiconductor body 10.

As can be seen in figure 1, the semiconductor device 100 is subdivided into a plurality of so-called "transistor half-cells". One such transistor half-cell HF is shown in greater detail in figure 3. The transistor half-cell HF is the structure between the vertical dashed lines in figure 3. In figures 1 and 2, several such transistor half-cells HF are arranged one after the other in a first lateral direction, running from the left to the right. Two adjacent half-cells HF are mirrored with respect to each other at the plane running perpendicularly to the first lateral direction and through the third base region 13c (see right vertical dashed line in figure 3). The half-cells each have a lateral extension W4 in the first lateral direction.

As can be seen in figure 3, the half-cell HF comprises a portion (half) of a first base region 13c, a first-type trench 51, a second base region 13b, a second-type trench 52 and a portion (half) of a third base region 13c which are arranged one after the other in this order along the first lateral direction. The half-cell HF further comprises an injection region 12 (source region 12) of the first conductivity type, i.e. n-type, arranged vertically between the first base region 13c and the top side 11. The injection region 12 adjoins the first base region 13c and the first-type trench 51. The injection region 12 further adjoins the emitter electrode 2 and is in electrical contact therewith.

Figure 4 shows the RC-IGBT 100 of figures 1 to 3 in top view onto the collector side 19. As can be seen here, the semiconductor body 10 comprises, besides the mixed region 18, a pilot region 18'. The pilot region 18' is also of the second conductivity type, i.e. p-type. Furthermore, it can be seen that the mixed region 18 laterally completely surrounds the pilot region 18'. The edge region 18'' laterally completely surrounds the mixed region 18 and the pilot region 18' .

The pilot region 18' has a round shape, namely the shape of a circle. The first-type regions 15 of the mixed region 18 are all elongated, stripe-shaped and extend radially with respect to a reference point Z which coincides with the center of the pilot region 18'.

As can be further seen in figure 4, the number of first-type regions 15 of the mixed region 18 increases stepwise in the direction away from the reference point Z. Indeed, the mixed region 18 can be subdivided into three steps. Each step is assigned an area which completely surrounds the pilot region 18'. The area assigned to the innermost step is ring-shaped. The area assigned to the next, radially more outward step is also ring-shaped. The area of the outermost step is delimited by a square shaped contour.

The number of first-type regions 15 increases from the innermost step (innermost ring) to the intermediate step (intermediate ring) and again increases from the intermediate step to the outermost step. With such a stepwise increase in the number of the first-type regions 15, the desired diode area can be maintained.

Particularly, as can be seen in figure 4, the density of first-type regions 16 decreases monotonously within each step when moving in a direction away from the reference point Z. At the transition to the next step, the density increases abruptly and then again decreases monotonously within this next step.

It can also be seen in figure 4 that the second-type region 16 the second conductivity type extends contiguously from the pilot region 18' to the edge region 18'' . This enables the electron hole plasma produced during operation to distribute evenly over the entire extension of the RC-IGBT 100.

With this design, the snapback is minimized since the pilot region is large due to the circular design. This is of particular importance for LV ultra-thin devices where the design rules for first snapback elimination and pilot-IGBT design depend on device thickness. The mixed region surrounding the pilot region with alternating p- and n-type regions is designed accordingly in order to minimize secondary snapback and increase SOA limits. Indeed, carrier injection can become uneven after the first snapback event if the mixed region is not properly designed and distributed around the pilot region. During IGBT conduction, plasma density is at its highest in the middle of the active region and directly above the pilot projecting from it. Consequently, temperature at the center of the RC-IGBT is significantly higher in comparison to the traditional separate diode and IGBT approach. This is exacerbated even further in LV ultra-thin devices where plasma distribution can already be problematic. Furthermore, during IGBT turn-off, dynamic avalanche, that contributes to increased turn-off losses mainly at low temperatures and low currents, starts early at the cells located directly on top of the pilot region compromising BiGT device reliability. Here, the design of the mixed region is chosen in order to guarantee smooth electrical characteristics and SOA performance.

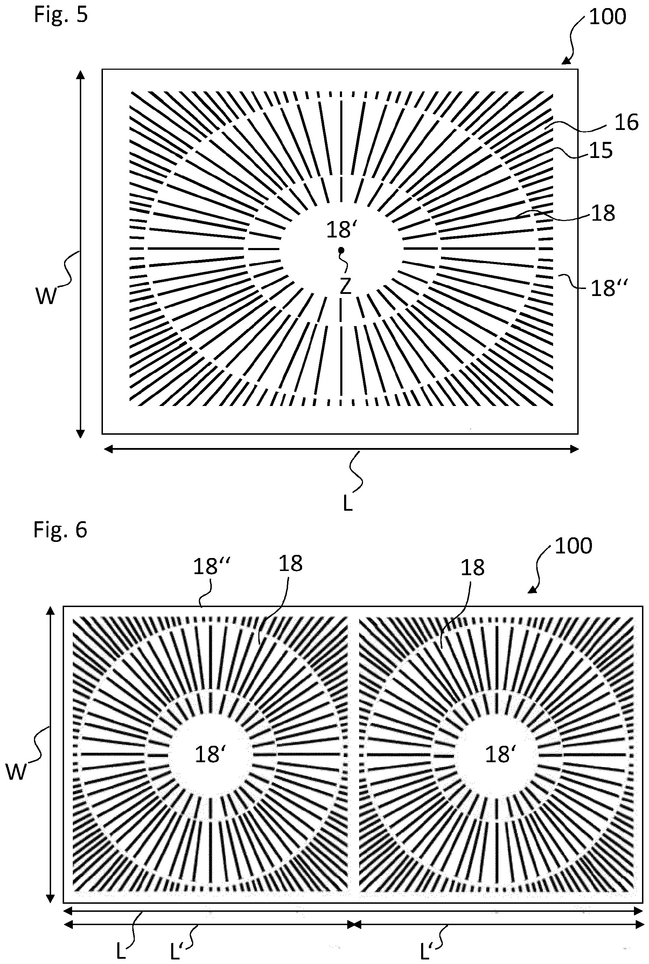

Figure 5 shows a further exemplary embodiment of an RC-IGBT 100, again in top view onto the collector side 19. Here, the collector side 19 is rectangular-shaped with the length L and the width W being different. Accordingly, the pilot region 18' is not chosen to be circular-shaped but elliptical-shaped. The first-type regions 15 of the mixed region 18 again extend mainly radially, but now they all run perpendicularly to the elliptic contour defining and delimiting the pilot region 18'.

In figures 4 and 5, the length L is smaller than 2-times the width W. The contour delimiting or defining the pilot region 18' is chosen to follow the relation x²/a² + y²/b² = 1, with x and y being the coordinates on the collector side 19 with the center of the pilot region 18' having the coordinates x = 0 and y = 0 and with a and b being fixed numbers. Furthermore, in both figures 4 and 5, the following is fulfilled: 0.1 ≤ (2·a)/L ≤ 0.5, 0.1 ≤ (2·b)/W ≤ 0.5 and (2·a)/L = (2·b)/W. In case of figure 4, W = L and a = b.

Figure 6 shows a further exemplary embodiment of the RC-IGBT 100 in top view onto the collector side 19. In this case, L ≥ 2·W. Therefore, the collector side 19 comprises two mixed regions 18 which each surround a uniquely assigned pilot region 18'. The pilot regions 18' each fulfill 0.1 ≤ (2·a)/L' ≤ 0.5, 0.1 ≤ (2·b)/W ≤ 0.5 and (2·a)/L' = (2·b)/W with L'·c = L, c being an integer and being the number of pilot regions 18'. In this case, L' = L/2.

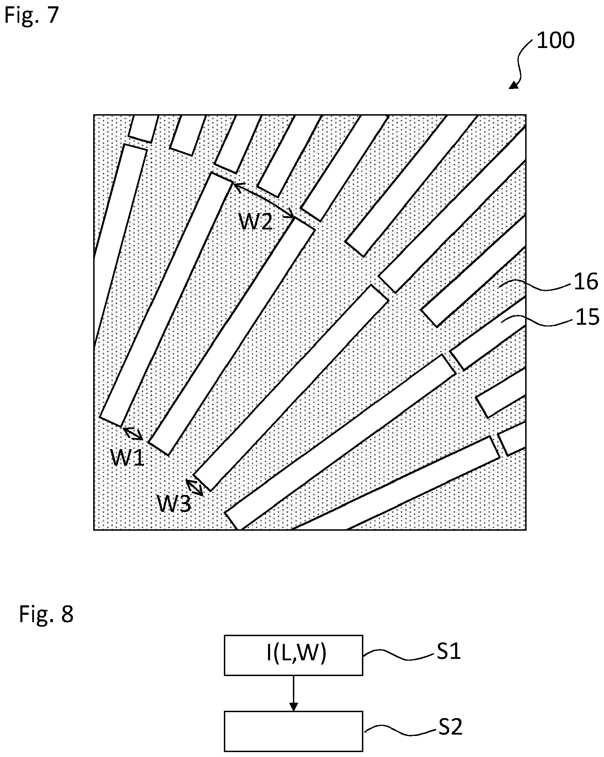

Figure 7 shows a portion of the collector side 19 of figure 4 in greater detail. As can be seen here, the distance between two adjacent first-type regions 15 within one step, wherein the distance is measured in the direction perpendicular to the radial direction, i.e. in azimuthal direction, increases continuously when moving in a radial outward direction, namely from a first value W1 to a second value W2. Thereby, the following constraints are met: W2 > W1 and W2 ≤ 4·W1. At the transition to the next step, the number of first-type regions 15 is increased so that in the next step the value W1 is again smaller than the value W2 of the previous step.

Moreover, the width W3 of each first-type region 15 is smaller than the first value W1. Additionally, the extension W4 of a transistor half-cell HF, as indicated in figure 3, is smaller than the width W3.

Figure 8 shows a flow chart of an exemplary embodiment of the method for producing an RC-IGBT. In the step S1, information I is provided which is representative for the length L and width W of the collector side 19 of the to-be-produced RC-IGBT, wherein L ≥ W.

In a step S2, a semiconductor body 10 with an emitter side 11 and a collector side 19 is produced depending on the provided information I, such that the semiconductor body 10 comprises at least one mixed region 18 at the collector side 19.
The mixed region 18 comprises a plurality of first-type regions 15 which are of a first conductivity type and which are laterally spaced apart from each other by semiconductor material of a second conductivity type. In top view onto the collector side 19, the first-type regions 15 of the mixed region 18 are each formed in an elongated manner and each extend ray-like away from a reference point Z of the mixed region 18. The number of first-type regions 15 of the mixed region 18 increases stepwise in a direction away from the reference point Z. If L ≥ 2·W, the semiconductor body is produced with two or more such mixed regions 18, and, if L < 2·W, the semiconductor body is produced with only one such mixed region.

The embodiments shown in the Figures 1 to 8 as stated represent exemplary embodiments of the improved RC-IGBT and improved method for producing an RC-IGBT; therefore, they do not constitute a complete list of all embodiments according to the improved RC-IGBT and method. Actual RC-IGBTs and methods may vary from the embodiments shown in terms of arrangements, devices and method steps, for example.

### Reference Signs

- 2: emitter electrode
- 3: collector electrode
- 4: gate electrode
- 10: semiconductor body
- 11: emitter side
- 12: injection region
- 13: base region
- 13a: first base region
- 13b: second base region
- 13c: third base region
- 14: drift region
- 15: first-type region
- 16: second-type region
- 18: mixed region
- 18': pilot region
- 18": edge region
- 19: collector side
- 40: electrically insulating layer / gate insulation layer
- 51: first-type trench
- 52: second-type trench
- 100: RC-IGBT
- W: width
- L: length
- W1: first value
- W2: second value
- W3: width
- W4: extension
- I: information
- S1, S2: method steps

## Claims

1. Reverse-Conducting Insulated Gate Bipolar Transistor (100) comprising
- a semiconductor body (10) with an emitter side (11) and a collector side (19), wherein
- the semiconductor body (10) comprises at least one mixed region (18) at the collector side (19),
- the mixed region (18) comprises a plurality of first-type regions (15) which are of a first conductivity type and which are laterally spaced apart from each other by semiconductor material of a second conductivity type,
- in top view onto the collector side (19)
- the first-type regions (15) of the mixed region (18) are each formed in an elongated manner and each extend ray-like away from a reference point (Z) of the mixed region (18),
- the number of first-type regions (15) of the mixed region (18) increases stepwise in a direction away from the reference point (Z).

2. Reverse-Conducting Insulated Gate Bipolar Transistor (100) according to claim 1, wherein
- the semiconductor body (10) comprises at least one pilot region (18') at the collector side (19) and adjoining the mixed region (18),
- the pilot region (18') is of the second conductivity type,
- in top view onto the collector side (19), the reference point (Z) lies in the pilot region (18'),
- the area of the pilot region (18') is at least d·d, wherein d is the thickness of the semiconductor body (10).

3. Reverse-Conducting Insulated Gate Bipolar Transistor (100) according to claim 2, wherein
- in top view onto the collector side (19), the mixed region (18) completely surrounds the pilot region (18').

4. Reverse-Conducting Insulated Gate Bipolar Transistor (100) according to claim 2 or 3, wherein
- in top view onto the collector side (19), a second-type region (16) of the second conductivity type extends contiguously from the pilot region (18') to the edge of the mixed region (18).

5. Reverse-Conducting Insulated Gate Bipolar Transistor (100) according to any one of the preceding claims, wherein
- in top view onto the collector side (19), the first-type regions (15) are evenly distributed around the reference point (Z).

6. Reverse-Conducting Insulated Gate Bipolar Transistor (100) according to any one of the preceding claims, wherein
- in top view onto the collector side (19), each step of the stepwise increase is assigned an area of the collector side (19) and
- at least the area assigned to one step is ring-shaped.

7. Reverse-Conducting Insulated Gate Bipolar Transistor (100) according to any one of the preceding claims, wherein
- the number of first-type regions (15) changes from one step to the adjacent step by a factor of at least 2.

8. Reverse-Conducting Insulated Gate Bipolar Transistor (100) according to any one of the preceding claims, wherein
- within a step, the distance between each adjacent first-type regions (15) has a first value (W1) in the region closest to the reference point (Z) and a second value (W2) in a region furthest away from the reference point (Z),
- the second value (W2) is greater than the first value (W1) but is at most 4-times the first value (W1).

9. Reverse-Conducting Insulated Gate Bipolar Transistor (100) according to claim 8, wherein
- the width (W3) of the first-type regions (15), measured perpendicularly to their respective main extension directions, is at most half the first value (W1).

10. Reverse-Conducting Insulated Gate Bipolar Transistor (100) according to any one of the preceding claims, further comprising
- a plurality of transistor half-cells (HC) arranged one after the other in a first lateral direction,
- the extensions (W4) of the transistor half-cells (HC) measured in the first lateral direction are smaller than the widths (W3) of the first-type regions (15).

11. Reverse-Conducting Insulated Gate Bipolar Transistor (100) according to claim 2 or any one of claims 3 to 10 in its dependency on claim 2, wherein
- in top view onto the collector side (19), the pilot region (18') has a round shape and is delimited by a contour following the relation x²/a² + y²/b² = 1, with x and y being the coordinates on the collector side (19) with the center of the pilot region (18') having the coordinates x = 0 and y = 0 and with a and b being fixed numbers,
- the collector side (19) has a rectangular shape with the edges of the rectangle having the length L and the width W and with L ≥ W,
- the area and shape of the pilot region (18') is chosen in dependence on the area and shape of the collector side (19) according to the following rules:
- if L < 2·W, then the collector side (19) comprises only one pilot region (18') surrounded by a mixed region (18), wherein the contour delimiting the pilot region (18') fulfills 0.1 ≤ (2·a)/L ≤ 0.5, 0.1 ≤ (2·b)/W ≤ 0.5 and (2-a)/L = (2-b)/W, and
- if L ≥ 2·W, then the collector side (19) comprises several pilot regions (18') each surrounded by a mixed region (18) and each pilot region (18') being delimited by a contour which fulfills 0.1 ≤ (2·a)/L' ≤ 0.5, 0.1 ≤ (2·b)/W ≤ 0.5 and (2·a)/L' = (2·b)/W with L'·c = L, c being an integer and being the number of pilot regions (18').

12. Reverse-Conducting Insulated Gate Bipolar Transistor (100) according to any one of the preceding claims, wherein
- the semiconductor body (10) comprises an edge region (18") at the collector side (19),
- the edge region (18'') is of the first or the second conductivity type and laterally surrounds the mixed region (18) .

13. Reverse-Conducting Insulated Gate Bipolar Transistor (100) according to claim 12, wherein
- the edge region (18'') is of the second conductivity type and has a lower doping concentration than the semiconductor material of the second conductivity type arranged laterally between the first-type regions (15).

14. Reverse-Conducting Insulated Gate Bipolar Transistor (100) according to claim 12, wherein
- the edge region (18'') is of the first conductivity type.

15. Method for producing a Reverse-Conducting Insulated Gate Bipolar Transistor (100), comprising
- providing information (I) which is representative for a length L and a width W to be had by a collector side (19) of the to-be-produced Reverse-Conducting Insulated Gate Bipolar Transistor (100), wherein L ≥ W,
- producing a semiconductor body (10) with an emitter side (11) and a collector side (19) depending on the provided information (I) such that,
- the semiconductor body (10) comprises at least one mixed region (18) at the collector side (19),
- the mixed region (18) comprises a plurality of first-type regions (15) which are of a first conductivity type and which are laterally spaced apart from each other by semiconductor material of a second conductivity type,
- in top view onto the collector side (19)
- the first-type regions (15) of the mixed region (18) are each formed in an elongated manner and each extend ray-like away from a reference point (Z) of the mixed region (18),
- the number of first-type regions (15) of the mixed region (18) increases stepwise in a direction away from the reference point (Z),
- if L ≥ 2·W, the semiconductor body (10) is produced with two or more such mixed regions (18), and, if L < 2·W, the semiconductor body (10) is produced with only one such mixed region (18).
